Europäisches Patentamt

European Patent Office

Office européen des brevets

(19)

(11) EP 0 655 836 B1

(12) EUROPÄISCHE PATENTSCHRIFT

(45) Veröffentlichungstag und Bekanntmachung des Hinweises auf die Patenterteilung:
21.10.1998 Patentblatt 1998/43

(51) Int Cl.6: **H03K 7/06**, H03K 7/08, G06F 1/03

(21) Anmeldenummer: 94117420.3

(22) Anmeldetag: 04.11.1994

(54) **Verfahren zur Ansteuerung von analogen Stellgliedern**

Method for the control of analog actuators

Procédé pour la commande d'actionneurs analogiques

(84) Benannte Vertragsstaaten:
DE ES FR GB IT SE

(30) Priorität: 29.11.1993 DE 4340520

(43) Veröffentlichungstag der Anmeldung:
31.05.1995 Patentblatt 1995/22

(73) Patentinhaber: TEMIC TELEFUNKEN microelectronic GmbH
74072 Heilbronn (DE)

(72) Erfinder:
• Heinzler, Stefan
D-88074 Meckenbeuren (DE)
• Jochum, Herbert
D-88263 Horgenzell (DE)

(74) Vertreter: Maute, Hans-Jürgen, Dipl.-Ing.
TEMIC TELEFUNKEN microelectronic GmbH
Postfach 35 35
74025 Heilbronn (DE)

(56) Entgegenhaltungen:
EP-A- 0 257 820          EP-A- 0 443 242
GB-A- 1 560 233          US-A- 3 654 450
US-A- 5 053 729

**Beschreibung**

Analoge Stellglieder (beispielsweise Lampen oder Ventile) müssen auf bestimmte analoge Werte (die beispielsweise ein Maß für die Lampenhelligkeit oder die Ventilöffnung sind) eingestellt werden. Die Ansteuerung der Stellglieder zur Vorgabe der gewünschten Analogwerte (die oftmals unterschiedlich bzw. variabel sind) wird in der Regel mittels Pulsweitenmodulation realisiert: der Analogwert wird durch ein bestimmtes Tastverhältnis (Verhältnis von Einschaltzeit bzw. Pulszeit zur Periodendauer der Ansteuerperiode) definiert, das Tastverhältnis über den Zählerstand eines digitalen Zählers vorgegeben, der Zählerausgang beim Erreichen des Zählerstandes umgeschaltet und das Stellglied abhängig vom Schaltzustand des Zählerausgangs angesteuert. Optional kann das digitale Ausgangssignal des Zählers (beispielsweise durch ein Filter) geglättet und ein steuerbarer Gleichstrom zum stromabhängigen Ansteuern des Stellglieds erzeugt werden. Eine Ansteuerung der Stellglieder mit variablen Analogwerten wird dadurch realisiert, daß - bei konstanter Periodendauer des Ansteuersignals - das Tastverhältnis durch eine Variation der Einschaltzeit/Pulszeit abgeändert wird; hierbei ist eine Variation des Tastverhältnisses in diskreten Schritten mit der Schrittweite des Zählers möglich.

Problematisch bei dem beschriebenen Verfahren ist jedoch, daß

- das Tastverhältnis nach jeder Ansteuerperiode (beispielsweise in einen Speicher) geladen werden muß,

- bedingt durch die diskreten Abstufungen des Zählers und abhängig von bestimmten systembedingten Eigenschaften (beispielsweise zu großer Periodendauer des Ansteuersignals, zu kleiner Zählerschrittweite, zu geringer Filterwirkung) sich die Einschaltzeiten/Ausschaltzeiten (insbesondere bei langen Pausenzeiten oder Pulszeiten) bemerkbar machen,

- durch eine Erhöhung der Grundfrequenz bzw. einer Verringerung der Periodendauer des Ansteuersignals die Pulsweitenmodulation einer erhöhten Belastung ausgesetzt und der Aufwand für die Einstellung des gewünschten Tastverhältnisses größer wird.

Der Erfindung liegt die Aufgabe zugrunde, ein einfaches Verfahren zur Ansteuerung von analogen Stellgliedern anzugeben, bei dem die genannten Nachteile vermieden werden und das vorteilhafte Eigenschaften aufweist.

Diese Aufgabe wird erfindungsgemäß durch die Merkmale a) bis d) des Patentanspruchs 1 gelöst.

Vorteilhafte Weiterbildungen des Verfahrens ergeben sich aus den Unteransprüchen.

Beim vorgestellten Verfahren wird das vorzugebende Tastverhältnis TV als Verhältnis eines Additionswerts AW zu einem Additionsmaximalwert AMW definiert:

$$TV = \frac{AW}{AMW} \bullet 100 \ [\%] \qquad\qquad (1);$$

der Additionsmaximalwert AMW ist beispielsweise durch die zur Verfügung stehende Zahl an Speicherplätzen bestimmt.

In aufeinanderfolgenden Additionsschritten (Zykluszeit der Addition: $t_Z$) wird der Additionswert AW vermöge eines Additionsglieds mit Speicherfunktion und Überlauferkennung zum bisherigen Speicherwert addiert, das Additionsergebnis als neuer Speicherwert abgespeichert und das Stellglied vom Überlauf des Additionsglieds angesteuert: wenn beim Additionsschritt ein Überlauf entsteht, wird am Signalausgang ein bestimmter Logikzustand ausgegeben (beispielsweise eine logische "1"), dies entspricht einer Pulszeit $t_{PU}$/Einschaltzeit; andernfalls wird der komplementäre Logikzustand ausgegeben (beispielsweise eine logische "0"), dies entspricht einer Pausenzeit $t_{PA}$/Ausschaltzeit. Beispielsweise wird ein gewünschtes Tastverhältnis von 50 % bei einem Additionsmaximalwert AMW von 100 Einheiten gemäß Gleichung (1) durch den Additionswert AW = TV • AMW = 50 realisiert, so daß (bei einer Schrittweite von einer Einheit) in aufeinanderfolgenden Additionsschritten abwechselnd eine logische "1" und eine logische "0" ausgegeben wird.

Das Tastverhältnis TV kann nach Ablauf der Zeitdauer $t_Z$ • AMW aus Gleichung (1) bestimmt werden. Die (während der Zeitdauer $t_Z$ • AMW gemittelte) Periodendauer T der Ansteuerperiode als Summe aus Pulszeit $t_{PU}$ und Pausenzeit $t_{PA}$ hängt ebenfalls vom Additionswert AW und dem Additionsmaximalwert AMW ab:

$$T = t_{PU} + t_{PA} = t_Z \bullet \left(\frac{AMW}{AW}\right) \qquad \text{für } AW \leq \frac{AMW}{2} \qquad\qquad (2a)$$

EP 0 655 836 B1

$$T = t_{PU} + t_{PA} = t_Z \bullet \left(\frac{AMW}{AMW - AW}\right) \qquad \text{für } AW \geq \frac{AMW}{2} \qquad (2b)$$

$t_Z$ ist wie oben erwähnt die Zykluszeit für den Additionsschritt.

Bei einer gleichförmigen Ansteuerung des Stellglieds wird das Tastverhältnis TV und gemäß Gleichung (1) damit auch der Additionswert AW in allen Zykluszeiten $t_Z$ konstant gehalten. Beispielsweise soll das konstante Tastverhältnis TV von 25 % mittels eines Registers im Byte-Format mit 256 Speicherplätzen (Schrittweite = 1) und einer Zykluszeit $t_Z$ von 1 ms eingestellt werden. Hierzu wird in sukzessiven Additionsschritten gemäß Gleichung (1) jeweils der Additionswert $AW = TV \bullet AMW = 64$ in das Register addiert; somit gibt sich bei jedem vierten Additionsschritt ein Überlauf, woraus sich eine Folge an Pausenzeiten $t_{PA}$ und Pulszeiten $t_{PU}$ von jeweils der Dauer $t_{PA} = 3$ ms und $t_{PU} = 1$ ms und demzufolge das gewünschte Tastverhältnis von TV = 25 % ergibt. Die (konstante) Periodendauer T als Summe aus Pausenzeit $t_{PA}$ und Pulszeit $t_{PU}$ beträgt in diesem Falle gemäß Gleichung (2a) T = 4 ms.

Zur variablen Ansteuerung des Stellglieds muß der Analogwert und damit auch das Tastverhältnis TV und der Additionswert AW für den jeweiligen Additionsschritt abgeändert werden: muß das Tastverhältnis TV inkrementiert oder dekrementiert werden, wird der Additionswert AW entsprechend der Gleichung (1) inkrementiert oder dekrementiert, wodurch bei den darauffolgenden Additionsschritten auch die Häufigkeit eines Überlaufes variiert wird; insbesondere lassen sich durch Vorgabe eines bestimmten zeitlichen Verhaltens bei der Änderung des Tastverhältnisses TV zeitliche Regelvorgänge (beispielsweise die Dauer eines Dimmvorgangs) steuern. Bei einem Ausführungsbeispiel hierzu - der gedimmten Ansteuerung einer Innenlicht-Glühlampe in einem Kraftfahrzeug - wird das Tastverhältnis TV von 100 % (Lampe immer ein) bis auf 0 % (Lampe immer aus) variiert. Hierzu wird bei einem Register mit 256 Speicherzellen, der Schrittweite 1 und der Zykluszeit $t_Z = 1,25$ ms ein in Zeitabständen von jeweils 1,25 ms dekrementierter Additionswert AW sukzessive zum Speicherwert aufaddiert.

Das vorgestellte Verfahren vereinigt mehrere Vorteile in sich:

- es ist eine optimale Verteilung der Pulszeiten/Pausenzeiten für die Ansteuerung der Stellglieder gegeben,

- es wird die maximal mögliche Grundfrequenz - bei vorgegebenem Tastverhältnis - eingestellt, wodurch Ein-/Auszustände nicht mehr sichtbar werden,

- es ist ein beliebiges zeitliches Verhalten für die Ansteuerung vorgebbar; insbesondere kann eine schnelle Reaktion auf gewünschte Änderungen erfolgen.

**Patentansprüche**

1. Verfahren zur Ansteuerung von analogen Stellgliedern wobei:

   a) ein Tastverhältnis (TV) als Relativverhältnis von Pulszeit ($t_{PU}$) zu Periodendauer (T) einer Ansteuerperiode vorgegeben wird,

   b) ein Additionswert (AW) als Produkt aus dem vorgegebenen Tastverhältnis (TV) und einem Additionsmaximalwert (AMW) definiert wird,

   c) Additionsschritte mit bestimmter Zykluszeit ($t_Z$) und jeweils vorgegebenem Additionswert (AW) sukzessiv aufeinanderfolgen,

   d) in jedem Additionsschritt der Additionswert (AW) durch ein Additionsglied mit Speicherfunktion und Uberlauferkennung zu dem im Additionsglied gespeicherten Wert addiert, das Additionsergebnis als neuer Speicherwert im Additionsglied abgespeichert, der Logikzustand am Ausgang des Additionsglieds von dem beim Additionsschritt auftretenden Überlauf festgelegt, und das Stellglied in Abhängigkeit des jeweiligen Logikzustands am Ausgang des Additionsglieds angesteuert wird.

2. Verfahren nach Anspruch 1, dadurch gekennzeichnet, daß bei jedem Additionsschritt im Falle des Auftretens eines Überlaufs eine logische "1" und beim Nicht-Auftreten eines Überlaufs eine logische "0" am Ausgang des Additionsglieds ausgegeben wird.

3. Verfahren nach Anspruch 1 oder 2, dadurch gekennzeichnet, daß der Additionsmaximalwert (AMW) durch die maximale Speicherkapazität des Additionsglieds festgelegt wird.

3

**4.** Verfahren nach einem der Ansprüche 1 bis 3, dadurch gekennzeichnet, daß bei einer konstanten Ansteuerung der Stellglieder das Tastverhältnis (TV) und damit der Additionswert (AW) bei jedem Additionsschritt als konstanter Wert vorgegeben wird.

**5.** Verfahren nach einem der Ansprüche 1 bis 3, dadurch gekennzeichnet, daß bei einer variablen Ansteuerung der Stellglieder das Tastverhältnis und damit der Additionswert (AW) bei jedem Additionsschritt (AW) beliebig vorgegeben werden kann.

**Claims**

1. Method of controlling analogue control elements wherein:

   a) a duty ratio (TV) is provided as the relative ratio of the pulse duration ($t_{PU}$) to the periodic time (T) of a control period,

   b) an addition value (AW) is defined as the product of the given duty ratio (TV) and a maximum addition value (AMW),

   c) adding steps each having a specific cycle time ($t_Z$) and a respective predetermined addition value (AW) follow in succession,

   d) in each adding step, the addition value (AW) is added by an adding member to a value stored in the adding member which incorporates a storage function and an overflow detecting function, the result of the addition is stored in the adding member as a new storage value, the logical state at the output of the adding member is determined by the overflow occurring during the adding step, and the control element is controlled in dependence on the logical state existing at the output of the adding member.

2. Method in accordance with Claim 1, characterised in that, in each adding step, a logical "1" is provided at the output of the adding member in the case where an overflow occurs and a logical "0" is provided when an overflow does not occur.

3. Method in accordance with Claim 1 or 2, characterised in that the maximum addition value (AMW) is determined by the maximum storage capacity of the adding member.

4. Method in accordance with any of the Claims 1 to 3, characterised in that, in the case where the control of the control element is constant, the duty ratio (TV) and hence the addition value (AW) is provided as a constant value in each adding step.

5. Method in accordance with any of the Claims 1 to 3, characterised in that, in the case where the control of the control element is variable, the duty ratio (TV) and hence the addition value (AW) can be provided in an arbitrary manner for each adding step (AW).

**Revendications**

1. Procédé d'intervention sur des élément réglés analogiques, dans lequel:

   a) un facteur de durée d'impulsion (TV) est prescrit sous forme du rapport entre la durée d'impulsion ($t_{PU}$) et la période (T) d'une période d'intervention,
   b) une valeur d'addition (AW) est définie sous forme du produit du facteur de durée d'impulsion (TV) prescrit et d'une valeur maximale d'addition (AMW),
   c) des pas d'addition d'une durée de cycle déterminée (tZ) et de, chacun, une valeur d'addition prescrite (AW), se suivent successivement,
   d) à chaque pas d'addition, la valeur d'addition (AW) est ajoutée, par un organe d'addition présentant une fonction mémoire et une reconnaissance de dépassement, à la valeur mémorisée dans l'organe d'addition, le résultat de l'addition est mémorisé dans l'organe d'addition en tant que nouvelle valeur en mémoire, l'état logique à la sortie de l'organe d'addition est déterminé par le dépassement qui apparaît lors du pas d'addition, et l'intervention sur l'élément réglé se fait en fonction de l'état logique en question à la sortie de l'organe d'addition.

2. Procédé selon la revendication 1, caractérisé par le fait qu'à chaque pas d'addition, dans le cas de l'apparition d'un dépassement, c'est un "1" logique qui est émis à la sortie de l'organe d'addition et, en cas de non apparition de dépassement, c'est un "0" logique.

3. Procédé selon la revendication 1 ou 2, caractérisé par le fait que la valeur maximale d'addition (AMW) est déterminée par la capacité maximale de la mémoire de l'organe d'addition.

4. Procédé selon l'une des revendications 1 à 3, caractérisé par le fait que dans le cas d'une intervention constante sur les éléments réglés, le facteur de durée d'impulsion (TW), et donc la valeur d'addition (AW), sont prescrits en tant que valeur constante à chaque pas d'addition.

5. Procédé selon l'une des revendications 1 à 3, caractérisé par le fait que dans le cas d'une intervention variable sur les éléments réglés, le facteur de durée d'impulsion, et donc la valeur d'addition (AW), peuvent être prescrits de façon quelconque à chaque pas d'addition (AW).